# EUROPEAN PATENT APPLICATION

(11) **EP 2 991 112 A1**
(43) Date of publication of application: **02.03.2016**
(21) Application number: 14182128.0
(22) Date of filing: 25.08.2014
(51) Int. Cl.: H01L 27/146, H01J 37/244, H01L 31/105

(54) **Improved radiation sensor, and its application in a charged-particle microscope**

(71) Applicant: FEI COMPANY, Hillsboro, Oregon 97124-5793 (US)
(72) Inventor: Veen, van, Gerard, 5581 HB Waalre (NL); Kooijman, Cornelis, 5501 BC Veldhoven (NL); Haspeslagh, Luc, 3210 Lubbeek-Linden (BE)
(74) Representative: Bakker, Hendrik

(57) **Abstract**

A pixelated CMOS radiation sensor (3) (e.g. in a 4T pinned photodiode device) that comprises a layered structure including:
- A p-type Si substrate (5);
- An n-doped region within said substrate (7);
- A p⁺-doped layer (9) that overlies said n-doped region;
- An SiOₓ layer (11) that overlies said p⁺-doped layer,

in which a Boron film (13) is deposited between said p⁺-doped layer and said SiOₓ layer. Application of such a (pure) Boron film serves to reduce leakage current by one or more orders of magnitude. Even a relatively thin Boron film (e.g. thickness 1-2 nm) can produce this effect.

## Description

The invention relates to a pixelated CMOS (Complementary Metal Oxide Semiconductor) radiation sensor that comprises a layered structure including:
- A p-type Si substrate;
- An n-doped region within said substrate;
- A p⁺-doped layer that overlies said n-doped region;
- An SiOₓ layer that overlies said p⁺-doped layer.

The invention also relates to a charged-particle microscope, comprising:
- A specimen holder, for holding a specimen;
- A source, for producing a beam of charged particles;
- A particle-optical column, for directing said beam so as to irradiate the specimen;
- A detector, for detecting radiation emanating from the specimen in response to said irradiation,
which detector comprises a sensor as set forth above.

Charged-particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" Focused Ion Beam (FIB), allowing supportive activities such as ion-beam milling or Ion-Beam-Induced Deposition (IBID), for example. More specifically:
- In a SEM, irradiation of a specimen by a scanning electron beam precipitates emanation of "auxiliary" radiation from the specimen, in the form of secondary electrons, backscattered electrons, X-rays and photoluminescence (infrared, visible and/or ultraviolet photons), for example; one or more components of this flux of emanating radiation is/are then detected and used for image accumulation purposes.
- In a TEM, the electron beam used to irradiate the specimen is chosen to be of a high-enough energy to penetrate the specimen (which, to this end, will generally be thinner than in the case of a SEM specimen); the flux of transmitted electrons emanating from the specimen can then be used to create an image. When such a TEM is operated in scanning mode (thus becoming a STEM), the image in question will be accumulated during a scanning motion of the irradiating electron beam. If desired, imagery in a STEM can also be accrued in the same way as in a SEM, *i.e.* by collecting auxiliary radiation emanating from the specimen.

More information on some of the topics elucidated here can, for example, be gleaned from the following Wikipedia links:
http://en.wikipedia.org/wiki/Electron microscope
http://en.wikipedia.org/wiki/Scanning electron microscope
http://en.wikipedia.org/wiki/Transmission_electron microscopy
http://en.wikipedia.org/wiki/Scanning_transmission electron_microscopy

As an alternative to the use of electrons as irradiating beam, charged-particle microscopy can also be performed using other species of charged particle. In this respect, the phrase "charged particle" should be broadly interpreted as encompassing electrons, positive ions (*e.g*. Ga or He ions), negative ions, protons and positrons, for instance. As regards ion-based microscopy, some further information can, for example, be gleaned from sources such as the following:
http://en.wikipedia.org/wiki/Scanning_Helium Ion_Microscope

- W.H. Escovitz, T.R. Fox and R. Levi-Setti, Scanning Transmission Ion Microscope with a Field Ion Source, Proc. Nat. Acad. Sci. USA 72(5), pp 1826-1828 (1975).

It should be noted that, in addition to imaging, a charged-particle microscope (CPM) may also have other functionalities, such as performing spectroscopy, examining diffractograms, performing (localized) surface modification (e.g. milling, etching, deposition), *etc.*

In all cases, a Charged-Particle Microscope (CPM) will comprise at least the following components:
- A radiation source, such as a Schottky electron source or ion gun.
- A particle-optical column, which serves to manipulate a "raw" radiation beam from the source, perform upon it certain operations such as focusing, aberration mitigation, cropping (with an aperture), filtering, *etc.,* and then irradiate (illuminate) a chosen specimen herewith. The particle-optical column will generally comprise one or more charged-particle lenses, and may comprise other types of particle-optical component also. If desired, it can be provided with a deflector system that can be invoked to cause its output beam to perform a scanning motion across the specimen being investigated. In the case of a TEM/STEM and transmission-type ion microscopes, a second particle-optical column will be positioned "downstream" of the specimen, serving as an imaging system to image transmitted charged particles onto a fluorescent screen and/or detector.

- A specimen holder, on which a specimen under investigation can be held and positioned (e.g. tilted, rotated). If desired, this holder can be moved so as to perform scanning motion of the irradiating beam w.r.t. the specimen. In general, such a specimen holder will be connected to a positioning system such as a mechanical stage.
- A detector, which may be unitary or compound/distributed in nature, and which can take many different forms, depending on the radiation being detected. Examples include photomultipliers (including solid-state photomultipliers, SSPMs), photodiodes, CMOS detectors, CCD detectors, photovoltaic cells, *etc.,* which may, for example, be used in conjunction with a scintillator film, for instance. A typical CPM may comprise several detectors, often of different types, and the quality, accuracy and reliability of such detectors is of major importance to the performance of the CPM.

In what follows, the invention may - by way of example - sometimes be set forth in the specific context of electron microscopy. However, such simplification is intended solely for clarity/illustrative purposes, and should not be interpreted as limiting.

A sensor as set forth in the opening paragraph above is known from so-called 4T (four-transistor) CMOS sensor designs. Each pixel in such a sensor comprises four transistors that co-operate with a so-called pinned photodiode, which has the abovementioned layered structure. See, for example, the following references:
http://fairchildimaging.com/files/spie_7021-2-pre-print.pdf
http://ieeexplore.ieee.org/stamp/stamp.jsp?arnumber=6742594
http://harvestimaging.com/pubdocs/125 2008 SSE CMOS overview.pdf

In such a layered structure:
- The (extrinsic) p-type substrate can be realized by appropriately doping an (intrinsic) Si substrate with a p-type dopant (such as Boron, for example). This can, for example, be achieved by continuously adding a (gas-phase) dopant during Si boule (crystal) growth.
- The n-doped region may, for example, be created by implanting Phosphorous ions (or ions of other pentavalent elements) into a portion of the p-type Si substrate. A typical concentration for such implantation is about 10¹⁵-10¹⁷ atoms per cm³, and the region itself may have a depth of the order of about 0.3-1.0 µm, for example. Lateral dimensions will very much depend on the particulars of the device concerned, but dimensions of the order of about 1-10 µm are conceivable/typical.
- The p⁺-doped layer may be created by implanting Boron ions (or ions of other trivalent elements) into a portion of the underlying structure. A typical dopant concentration in such a layer may be about 10¹⁷-10¹⁹ atoms per cm³, and the layer itself may have a depth of the order of 50-150 nm, for example.
- The SiOₓ layer may, for example, comprise SiO and/or SiO₂, and its thickness may be of the order of 3.0-6.0 µm, for instance. It may, for example, be deposited using low-temperature CVD (Chemical Vapor Deposition), compatible with back-end CMOS processing.

As regards the prefix "photo" in the term "photodiode", this should not be interpreted as indicating a device that can only detect photons; rather, the term (as used throughout this text) is intended to indicate a more generic device that can generate an electrical signal in response to interception of various types of particulate radiation (photons, electrons, ions, *etc.).* Use of an intermediary (such as a scintillator layer) to convert non-photonic radiation to photonic radiation is not generally required.

For more information on some of the topics alluded to here, reference is made to the following Wikipedia links:
http://en.wikipedia.org/wiki/Extrinsic semiconductor
http://en.wikipedia.org/wiki/Doping %28semiconductor%29

Although they are widely used for detection of various types of particulate radiation - such as photons, electrons, and ions - sensors of this type suffer from a number of disadvantages. In particular, such sensors can demonstrate a relatively large "leakage current" or "dark current", which is effectively a parasitic sensor output in the absence of an input flux of radiation. Such a leakage current can be problematic for a number of reasons:
- If it is too large relative to typical "bright current" values produced by the sensor (when the sensor is detecting radiation), the dynamic range of the sensor can suffer. In acute situations, the leakage current may actually saturate the sensor, so that it cannot produce any useful detection output.
- It requires the sensor to be calibrated, whereby the leakage current is measured, and its value is subtracted from the sensor's output current. However, the leakage current does not necessarily exhibit linear behavior, thus essentially requiring re-calibration on a "per measurement" basis, whereby "bright frame" and "dark frame" measurements are conducted in pairs, and the latter subtracted from the former each time. This obviously entails a throughput penalty.

These problems are compounded by the fact that, compared to a reference "virgin" sensor that has not been irradiated, the leakage current tends to increase as a function of the cumulative radiation dose to which the sensor is exposed. Consequently, the sensor tends to degrade with use *(vis-à-vis* leakage current), thereby potentially limiting its usefulness / usable lifetime.

It is an object of the invention to address these issues. In particular, it is an object of the invention to provide a sensor as described above, which, compared to prior-art sensors, suffers to a reduced extent from leakage current behavior. More specifically, it is an object of the invention that such a sensor should demonstrate improved radiation hardness, particularly in that it suffers less (and preferably no) increase in leakage current in response to a given radiation dose.

These and other objects are achieved in a sensor as set forth in the opening paragraph above, characterized in that a Boron film is deposited between said p⁺-doped layer and said SiOₓ layer.

In experiments leading to the invention, the inventors sought to investigate the mechanism that was responsible for production of leakage currents as referred to above. It appeared that fundamental structural differences between the sensor's (doped) Si underlayers and SiOₓ overlayer were playing a role in this phenomenon. More particularly, lattice mismatches in the interface zone between the Si and SiOₓ were leading to lattice defects - more specifically in the form of Si atoms that were not bonded to an optimal number of neighboring atoms, leading to the occurrence of dangling bonds. These dangling bonds acted as recombination/generation centers - capable of capturing a charge carrier, and, accordingly, disturbing the overall equilibrium of charge carriers in the device, with the attendant generation of leakage current flows. Often, hydrogen is used in CMOS devices in an attempt to passivate the Si/SiOₓ interface. Typically, when such a set-up is irradiated during a detection run, incoming radiation particles tend to (re-)create dangling bonds *(interalia* by disrupting Si-H bonds in the case of a H-passivated Si/SiOₓ interface) - allowing the whole process of carrier capture and leakage current generation to repeat itself once irradiation stops. Confronted with this phenomenon, the inventors conducted various experiments in which they ultimately observed that application of a thin film of Boron between the Si and SiOₓ lattices will cause the aforementioned recombination/generation centers to be occupied by a Boron atom, and that this is essentially a stable, permanent occupancy that is not undone *en masse* when the sensor is irradiated. Stable occupation of such centers by Boron atoms (with attendant elimination of associated dangling bonds) means that they can no longer act as carrier traps, with a resulting significant reduction in leakage current - typically by one or more orders of magnitude.

In addition to the effects set forth in the previous paragraph, the inventors also arrived at additional insights, as follows. When ionizing radiation passes through a SiOₓ layer, electron-hole pairs are generally formed. Electrons typically have relatively high mobility, and they will be collected by the closest positively biased electrode; however, holes tend to have very low mobility (orders of magnitude lower than electrons) and can stay trapped in the oxide for a timespan that can vary from a few seconds to many years, depending on the position where charges are created and the oxide thickness involved. The thicker the oxide, the longer the holes tend to be trapped, and this effect can lead to the formation of semi-permanent positive charge in the SiOₓ layer. Such positive charges in the SiOₓ above the photodiode tend to cause an effective doping reduction along the Si/SiOₓ interface. The higher the radiation dose, the more pronounced this effect becomes, causing the pinning layer (p⁺-doped layer) to lose effectiveness. The Boron film of the present invention counteracts this effect by "shielding" the pinning layer from the above-mentioned space charge effects in the SiOₓ layer.

As already stated above, a relatively thin film of Boron (*e.g*. 1-2 nm) is enough to produce the inventive effect being sought. A thicker layer is, in principle, possible, but the inventors have observed that relatively thin Boron films can exhibit more advantageous properties. For example, Boron occurs in column III of the periodic table of the elements, together with metals such as Al, Ga, In and TI; however, Boron itself is a metalloid, with properties intermediate between those of metals and non-metals. By keeping the Boron film in the inventive sensor thin, the inventors have observed that its behavior migrates (further) away from metallic behavior and toward semiconductor behavior. This can produce some surprising results: for example, one might think that the presence of the inventive Boron film in a pinned photodiode structure would produce Schottky-like behavior but, surprisingly, normal diode behavior is preserved. It should be noted that Boron film thicknesses of less than 1 nm are, in principle, allowed by the current invention, though such films may be more difficult to deposit in a closed/contiguous form (rather than a patchwork of islands).

It should be noted that, when the current text refers to a "Boron film", it should be interpreted as indicating a film that is predominantly (or totally) comprised of Boron atoms. In practice, such a film may comprise relatively small quantities of impurities / interstitials, but the presence of minority numbers of foreign atoms still falls within the scope of the label "Boron film". In any case, it will be clear to the skilled artisan that a Boron film as here alluded to is a very different entity to a Boron-doped layer, in which Boron atoms are introduced as minority impurities in a layer of other majority atoms.

In an embodiment of the invention, the employed Boron film is deposited using Chemical Vapor Deposition (CVD). This may, for example, be achieved by using a mixture of B₂H₆ and H₂ as a precursor gas. CVD (including its various hybrids, such as PECVD, *etc.)* is advantageous in that it can be used to produce a thin, uniform film in a very controllable manner (as opposed, for example, to sputtering, which tends to grow layers *via* merging islands in a process that is generally less controllable). Other deposition techniques that could be employed to produce the present invention's characteristic Boron film include Molecular Beam Epitaxy (MBE) and Atomic Layer Deposition (ALD), for example.

For some general information on CVD, MBE and ALD, reference is made to the following Wikipedia links:
http://en.wikipedia.org/wiki/Chemical_vapor_deposition
http://en.wikipedia.org/wiki/Molecular beam epitaxy
http://en.wikipedia.org/wiki/Atomic layer deposition

The sensor of the current invention lends itself particularly to designs in which each pixel comprises (at least) 4 transistors. These include so-called 4T, 5T and 6T designs, for example. However, in principle, the invention could also be applied in other architectures, such as a 3T design, for example.

The invention will now be elucidated in more detail on the basis of exemplary embodiments and the accompanying schematic drawings, in which:
Figure 1 renders a cross-sectional view of part of an embodiment of a pixelated CMOS radiation sensor according to the current invention.
Figure 2 depicts a circuit diagram for a typical 4T (four-transistor) CMOS sensor design.
Figure 3 renders a graph of leakage current versus applied voltage for a test radiation sensor according to the prior art (squares) and the current invention (triangles), after exposure to a given high-energy electron dose.
Figure 4 renders a longitudinal cross-sectional view of a charged-particle microscope in which a radiation sensor according to the current invention can be employed.

In the Figures, where pertinent, corresponding parts are indicated using corresponding reference symbols. It should be noted that, in general, the Figures are not to scale.

### Embodiment 1

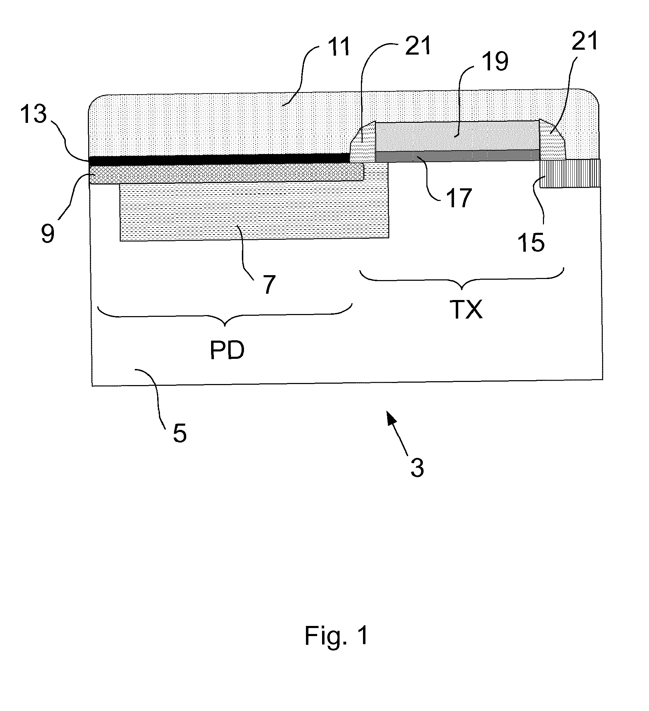

Figure 1 renders a cross-sectional view of part of an embodiment of a pixelated CMOS radiation sensor 3 according to the current invention. The layered structure depicted in the Figure comprises the following parts / aspects:
5: A p-type Si substrate, *e.g*. a Si crystal doped with a small quantity of B.
7: An n-doped region within p-type substrate 5.
9: A p⁺-doped layer ("pinning layer") that (at least partially) overlies the n-doped region 7.
11: An SiOₓ layer that (at least partially) overlies the p⁺-doped layer 9.
13: A Boron film deposited between p⁺-doped layer 9 and SiOₓ layer 11.

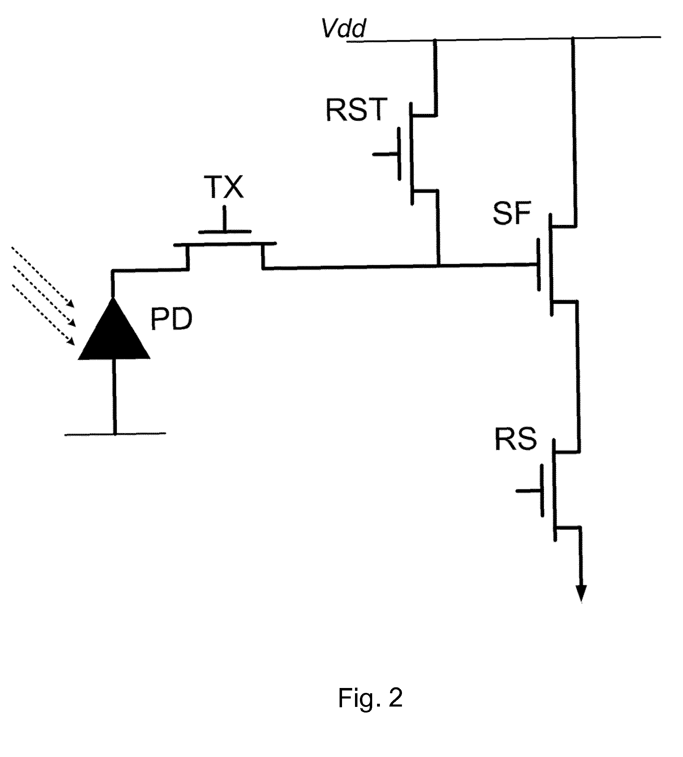

The components 5-13 comprise a pinned photodiode structure PD. In prior-art structures of this type, Boron film 13 is absent, and layer 11 sits directly atop layer 9. To the right of the Figure, some ancillary structures are visible, which will be better understood in the context of Figure 2 / Embodiment 2 below. Specifically, a Transfer Gate Transistor TX is depicted, which comprises the following (additional) parts / aspects:
15: An n-doped floating diffusion layer.
17: A gate oxide layer.
19: A polysilicon layer.
21: So-called spacers, *e.g.* comprising SiN (silicon nitride).

In use, radiation (such as a stream of electrons, photons or ions, for example) will impinge upon the SiOₓ layer 11. As set forth above, the presence of the Boron film 13 between structures 9 and 11 serves to fill dangling bond sites that can arise due to a mismatch between the Si lattice of layer 9 and the SiOₓ lattice of layer 11, thereby reducing the occurrence of carrier traps / leakage currents. The Boron film 13 also shields the pinning layer 9 from (irradiation-induced) positive charge accumulation in the SiOₓ layer 11. In effect, the Boron film 13 can be regarded as a "radiation shield" or "radiation-hardening film" for the sensor 3, in that it (ultimately) mitigates undesirable effects that can arise as an effect of irradiation.

### Embodiment 2

Figure 2 depicts a circuit diagram for (a single pixel of) a typical 4T (four-transistor) CMOS sensor design. The Figure comprises the following parts / aspects:
PD: Pinned photodiode.
TX: Transfer Gate Transistor.
RST: Reset Transistor.
SF: Source Follower Transistor.
RS: Row Select Transistor.
Vdd: Power Supply voltage.

Irradiation of the pinned photodiode PD during sensing operations is schematically illustrated by the dashed arrows impinging on it from the left. The subject of Figure 1 effectively illustrates an embodiment of the parts PD and TX of this circuit. The skilled artisan will understand that many variations of / supplements to this basic circuit schematic are possible, e.g. by including various capacitors in the layout. He will also understand that the CMOS sensor of the current invention does not necessarily have to be used in a 4T architecture; for instance, it could also be used in a 3T structure, or in a 5T structure, *e.g*. of a type as set forth in the following reference:
http://www.cse.vorku.ca/visor/resources/Tsai twostep readout.pdf

### Embodiment 3

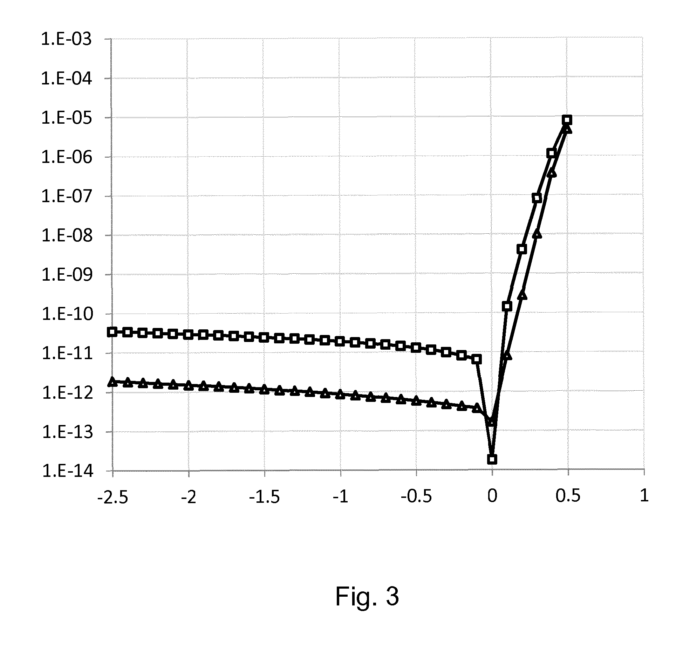

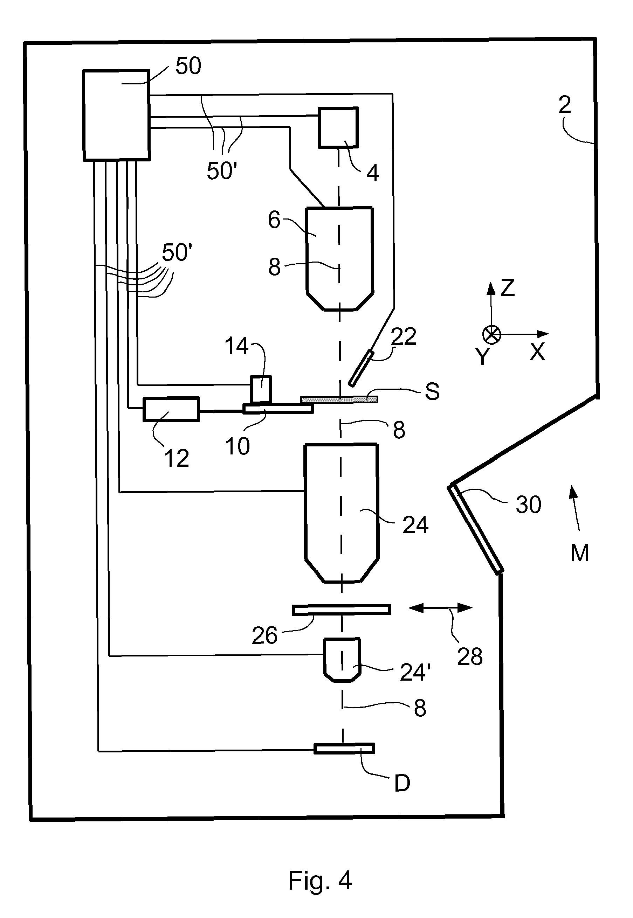

Figure 3 shows a graph of leakage current versus applied voltage for a test radiation sensor according to the prior art (squares; no boron film) and the current invention (triangles; boron film), after exposure to a given high-energy electron dose (see below). The employed radiation sensor had an architecture similar to that depicted in Figure 1, except in that an extra connection pad/via was provided down to the n-doped region (Fig. 1, item 7), to allow bias voltage to be adjusted (normally, a structure such as that shown in Figure 1 is self-biasing, with a bias voltage typically in the range -1 to -1.5 Volts). The vertical axis of the graph is logarithmic, and renders measured current in (exponents of) Amperes, whereas the horizontal axis is linear, and renders applied voltage in Volts. The data are depicted for a pixel area of 14x14 µm², and a dose per pixel of 1 GPE (Giga Primary Electron), corresponding to per-pixel irradiation with a billion electrons (*e.g.* along axis 8 in a set-up such as that shown in Figure 4). The tests were conducted at room temperature (20°C) and, for the test structure corresponding to the present invention (triangles), the employed Boron film (Fig. 1, item 13) had a thickness of one nanometer.

Looking at the part of the graph to the left of zero Volts, it is evident that there is a large difference in leakage current between the prior-art structure (squares; no boron film) and the inventive structure (triangles; boron film). In the present case, this difference amounts to a factor of ca. eighteen, *i.e.* the leakage current in the inventive structure is only about 5.5% of the leakage current in the prior-art structure. This is a striking illustration of the effectiveness of the present invention.

### Embodiment 4

Figure 4 is a highly schematic depiction of an embodiment of a CPM M that lends itself to use in conjunction with the current invention; the depicted microscope is a STEM *(i.e.* a TEM, with scanning functionality) but, in the context of the current invention, it could just as validly be an ion-based microscope, for example. In the Figure, within a vacuum enclosure 2, an electron source 4 (such as a Schottky gun, for example) produces a beam of electrons that traverse an electron-optical illuminator 6, serving to direct/focus them onto a chosen region of a (substantially planar) specimen S. This illuminator 6 has an electron-optical axis 8, and will generally comprise a variety of electrostatic / magnetic lenses, (scan) deflectors, correctors (such as stigmators), *etc*.; typically, it can also comprise a condenser system.

The specimen S is held on a specimen holder 10 that can be positioned in multiple degrees of freedom by a positioning device (stage) 12; for example, the specimen holder 10 may comprise a finger that can be moved *(inter alia)* in the XY plane (see the depicted Cartesian coordinate system). Such movement allows different regions of the specimen S to be irradiated / imaged / inspected by the electron beam traveling (in the -Z direction) along axis 8 (and/or allows scanning motion to be performed, as an alternative to beam scanning). An optional cooling device 14 is in intimate thermal contact with the specimen holder 10, and is capable of maintaining the latter at cryogenic temperatures, e.g. using a circulating cryogenic coolant to achieve and maintain a desired low temperature.

The (focused) electron beam traveling along axis 8 will interact with the specimen S in such a manner as to cause various types of "stimulated" radiation to emanate from the specimen S, including (for example) secondary electrons, backscattered electrons, X-rays and optical radiation (cathodoluminescence). If desired, one or more of these radiation types can be detected with the aid of detector 22, which might be a combined scintillator/photomultiplier or EDX (Energy-Dispersive X-Ray Spectroscopy) detector, for instance; in such a case, an image could be constructed using basically the same principle as in a SEM. However, alternatively or supplementally, one can study electrons that traverse (pass through) the specimen S, emerge from it and continue to propagate (substantially, though generally with some deflection/scattering) along axis 8. Such transmitted electrons enter an imaging system (combined objective/projection lens) 24, which will generally comprise a variety of electrostatic / magnetic lenses, deflectors, correctors (such as stigmators), *etc.* In normal (non-scanning) TEM mode, this imaging system 24 can focus the transmitted electrons onto a fluorescent screen 26, which, if desired, can be retracted/withdrawn (as schematically indicated by arrows 28) so as to get it out of the way of axis 8. An image of (part of) the specimen S will be formed by imaging system 24 on screen 26, and this may be viewed through viewing port 30 located in a suitable portion of the wall 2. The retraction mechanism for screen 26 may, for example, be mechanical and/or electrical in nature, and is not depicted here.

As an alternative to viewing an image on screen 26, one can instead make use of electron detector D, particularly in STEM mode. To this end, adjuster lens 24' can be enacted so as to shift the focus of the electrons emerging from imaging system 24 and redirect/focus them onto detector D (rather than the plane of retracted screen 26: see above). At detector D, the electrons can form an image (or diffractogram) that can be processed by controller 50 and displayed on a display device (not depicted), such as a flat panel display, for example. In STEM mode, an output from detector D (and/or detector 22) can be recorded as a function of (X,Y) scanning beam position on the specimen S, and an image can be constructed that is a "map" of detector output as a function of X,Y. The skilled artisan will be very familiar with these various possibilities, which require no further elucidation here.

Note that the controller (computer processor) 50 is connected to various illustrated components *via* control lines (buses) 50'. This controller 50 can provide a variety of functions, such as synchronizing actions, providing setpoints, processing signals, performing calculations, and displaying messages/information on a display device (not depicted). Needless to say, the (schematically depicted) controller 50 may be (partially) inside or outside the enclosure 2, and may have a unitary or composite structure, as desired. The skilled artisan will understand that the interior of the enclosure 2 does not have to be kept at a strict vacuum; for example, in a so-called "Environmental STEM", a background atmosphere of a given gas is deliberately introduced/maintained within the enclosure 2.

In the context of the current invention, detector D (and possibly also other detectors in the microscope M, such as detector 22) is embodied to comprise a pixelated CMOS radiation sensor as set forth above, comprising the characteristic "radiation-hardening" Boron film of the invention.

## Claims

1. A pixelated CMOS radiation sensor that comprises a layered structure including:
- A p-type Si substrate;
- An n-doped region within said substrate;
- A p⁺-doped layer that overlies said n-doped region;
- An SiOₓ layer that overlies said p⁺-doped layer,
**characterized in that** a Boron film is deposited between said p⁺-doped layer and said SiOₓ layer.

2. A sensor according to claim 1, wherein said Boron film has a thickness of at least 1 nm.

3. A sensor according to claim 1 or 2, wherein said Boron film is deposited using Chemical Vapor Deposition.

4. A sensor according to any preceding claim, wherein each pixel comprises four transistors.

5. A charged-particle microscope, comprising:
- A specimen holder, for holding a specimen;
- A source, for producing a beam of charged particles;
- A particle-optical column, for directing said beam so as to irradiate the specimen;
- A detector, for detecting radiation emanating from the specimen in response to said irradiation,
wherein said detector comprises a sensor according to any of claims 1-4.
